(19) Europäisches Patentamt

European Patent Office

Office européen des brevets

(11) Publication number: **0 342 971 B1**

# (12) EUROPEAN PATENT SPECIFICATION

(45) Date of publication of patent specification: **06.10.93**  (51) Int. Cl.⁵: **H05K 9/00**

(21) Application number: **89305016.1**

(22) Date of filing: **18.05.89**

(54) **Electric device.**

(30) Priority: **18.05.88 JP 122660/88**

(43) Date of publication of application:
**23.11.89 Bulletin 89/47**

(45) Publication of the grant of the patent:
**06.10.93 Bulletin 93/40**

(84) Designated Contracting States:
**DE FR GB**

(56) References cited:
**EP-A- 0 090 432**
**DE-A- 2 907 393**
**DE-A- 3 616 906**

(73) Proprietor: **MITSUBISHI MATERIALS CORPO-
RATION**
**5-1, Ohtemachi 1-chome**
**Chiyoda-ku, Tokyo(JP)**

(72) Inventor: **Wada, Hideaki**
**1014,, Ooaza Yokoze**
**Yokoze-machi**
**Chichibu-gun Saitama, 368(JP)**
Inventor: **Naoto, Kitahara**
**1019,, Ooaza Yokoze**
**Yokoze-machi**
**Chichibu-gun Saitama, 368(JP)**
Inventor: **Masami, Koshimura**
**1014,, Ooaza Yokoze**
**Yokoze-machi**
**Chichibu-gun Saitama, 368(JP)**
Inventor: **Mikiya, Ono**
**2435-47, Ooaza Kume, Tokorozawa-shi**
**Saitama 359(JP)**

(74) Representative: **Blanco White, Henry Nicholas
et al**
**ABEL & IMRAY**
**Northumberland House**
**303-306 High Holborn**
**London WC1V 7LH (GB)**

## Description

This invention is applicable to an electronic or other electrical device which can prevent leakage of undesirably generated electromagentic waves as well as reduce the influence of external noises. This invention relates to a box or casing for electronic and other electrical devices.

As electronic devices such as computers and digital electronic devices, in particular, have become increasingly popular, electromagnetic interference has come to pose serious problems. The problems are caused by electromagnetic waves leaking from or into electronic devices. In order to prevent electromagnetic interference, it is necessary to cover the device fully with a casing which is made of a shielding material and is joined without seams. Metal plates are conventionally used as a suitable material, but suffer from the disadvantage that they are difficult to shape in particular, desired forms. In practice, moreover, the casing should be easily detachable for maintenance purpose. Further, the need to provide an air vent for cooling purposes, and apertures for, for example, switches, connectors and a display screen prevents complete shielding.

When the device is encased within a moulded casing of a plastics material, the casing has previously been coated with metal on its internal surface or some other suitable coating has been applied with a view to achieving effective electromagnetic shielding.

If the casing is made of metal plates, the shape will in general not be optimum so that openings, especially an opening for a display screen, will be unnecessarily large. If the casing is formed by moulding a plastics material, on the other hand, the electromagnetic shielding provided by a coating on the inside of the casing will be found to give not entirely satisfactory performance. Further, it is difficult to treat a display screen to provide electromagnetic shielding. For those various reasons, it has proved difficult or impossible to reduce the leakage of electromagnetic waves to an acceptable level. As the number of electronic devices increases, the problem becomes more serious, because the tolerable amount of leakage per device is inevitably reduced (see also DE-A-3 616 906).

This invention aims to solve those problems encountered in the prior art, and to provide an electronic or other electrical device from which leakage of electromagnetic waves is significantly reduced to prevent the electromagnetic interference that would otherwise cause environmental problems, and to provide an electronic device that is significantly protected against interference caused by electromagnetic waves incident upon it.

This invention provides an electronic or other electrical device of which casing is mainly made of electromagnetic shielding material and which is characterised in that said casing is provided internally with an electromagnetic wave suppressor member made of a material which has high magnetic permeability and/or high permittivity at high frequencies and yet has electromagnetic loss.

The material has both high permeability and high permittivity at high frequencies (from 10MHz to 10GHz).

It is desirable to provide the suppressor member at a location close to the place where electromagnetic waves are less shielded. The suppressor member may be provided at a location close to a circuit which is prone to the effect of electromagnetic waves or close to a circuit which is likely to generate electromagnetic waves which might interfere with other devices.

The following expressions hold if complex permeability and complex permittivity are denoted respectively by $\mu$ and $\epsilon$ and the magnetic loss and dielectric loss are denoted respectively by $\mu''$ (the imaginary part of $\mu$) and $\epsilon''$ (the ima\ginary part of $\epsilon$).

$$\mu = \mu' - j\mu'', \epsilon = \epsilon' - j\epsilon''$$

wherein $j = (-1)^{1/2}$, and $\mu'$ and $\epsilon'$ denote respectively the effective permeability and effective permittivity.

Preferably, $\epsilon' > 20$ and $\epsilon'' > 1$, and/or $\mu' > 1$ and $\mu'' > 1$.

Ceramic materials with $\epsilon'$ and $\epsilon''$ of the order of 1000 and ferrite materials with $\mu'$ and $\mu''$ of the order of 500 can be obtained, and in general the higher the values achieved the better.

The electric field components of electromagnetic waves are at least partially absorbed when the waves are incident on a material having a large dielectric loss, and the magnetic field components are at least partially absorbed when the waves are incident on a material having a large magnetic loss.

Based on the above phenomena and formulae, if a member having a high permeability and a member having a high permittivity are suitably arranged inside an electronic device of which the casing is made mainly of electromagnetic shielding material and is provided with an opening, at least a substantial part of the electromagnetic waves that would otherwise leak from the opening can be absorbed within the casing thereby remarkably reducing the electromagnetic interference which would otherwise be caused by the device.

If the suppressor member has high permeability as well as high permittivity, arrangement of parts becomes extremely easy.

When the suppressor member is provided near an opening or a less shielded portion such as a display screen, in particular, the ratio of leaked electromagnetic waves becomes smaller.

When such suppressor member is provided close to the circuit which is prone to the influence of electromagnetic waves or the circuit which is likely to generate electromagnetic waves which interfere with other devices, it can suppress electromagnetic interference independently of the casing.

As this invention can reduce the level of electromagnetic waves leaking from an electronic device at least by 3 dB, it can achieve a remarkable effect as a preventive measure against electromagnetic interference.

Various forms of electrical device and electromagnetic wave suppressor members constructed in accordance with the invention will now be described by way of example only with reference to the accompanying drawings, in which:

Fig. 1 is an exploded explanatory view to show a first form of electrical device;

Fig. 2 is a graph to show the result of evaluation given to a first form of electromagnetic wave suppressor member;

Fig. 3 is a graph to show the result of evaluation given to a second form of electromagnetic wave suppressor member; and

Fig. 4 is an explanatory view to show a second form of electrical device.

Embodiments of this invention will now be described referring to drawings.

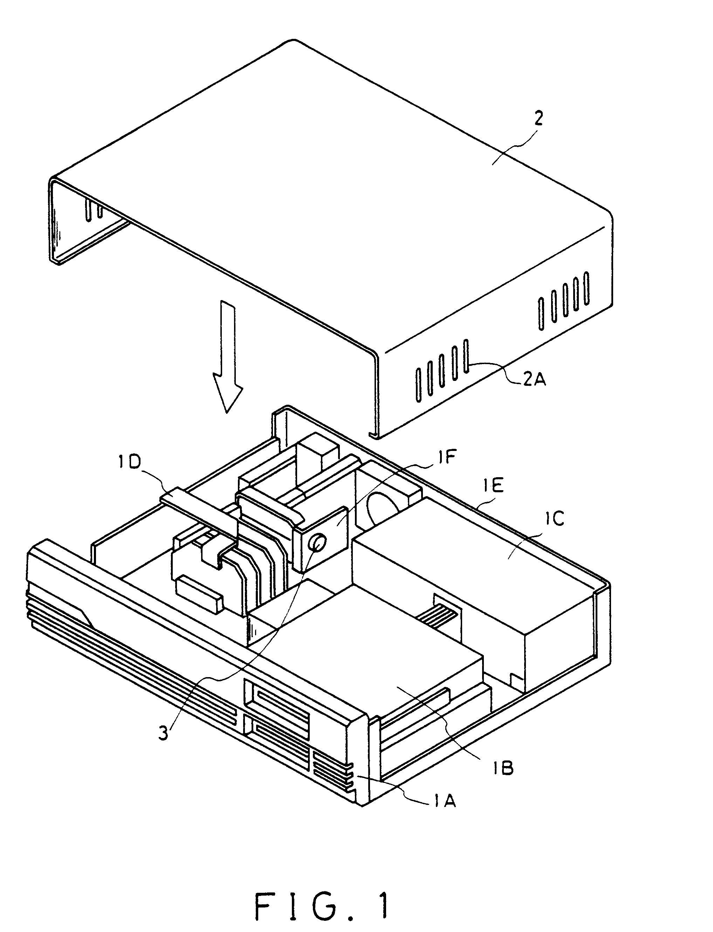

Fig. 1 is an exploded view to explain an embodiment of this invention in which the electronic device is a personal computer. In the figure, the frontal section 1A of a body 1 of the personal computer is molded with a plastics material and is provided with a shielding member on the internal surface thereof. A disc drive unit 1B and a power source 1C are covered respectively with metal plates while a printed circuit board 1D is exposed. A metal plate 1E is erected at the rear side of the device, and a metal plate (not shown) is inserted underneath those parts to form a bottom of the device. A metal casing 2 which has cooling vents or holes 2A is to be placed from above on the body 1. A metal plate (not shown) is inserted over the plastic molding or the frontal section 1A except for the inlet port for said disc drive unit 1B. The casing 2, the metal plate 1E at the back, and the metal plates at the bottom (not shown) and the frontal side 1A are made of electromagnetic shielding material. The disc unit 1B and power source 1C are also covered with metal plates. As stated above, the casing is almost all made of electromagnetic shielding material.

The reference numeral 1F denotes a partition plate provided between the printed circuit board 1D and the power source 1C.

An electromagnetic suppressor member 3 made of a material having high permeability or high permittivity at high frequencies as well as electromagnetic loss is provided on the partition plate 1F inside the casing.

The electromagnetic suppressor member 3 has at least either high permeability or high permittivity and therefore shows large magnetic loss and/or large dielectric loss. The volume of the member is 10% or less of the volume of the casing.

The material is a magnetic substance mainly comprising ferrite which is generally expressed as $MOFe_2O_3$ (wherein M denotes a metal selected from at least one of Mn, Ni, Mg, Co, Cu, Fe and Zn) or a ferroelectric substance having a perovskite structure. It preferably has both high permeability and high permittivity.

An example of a method of manufacturing such a material will now be given.

The starting materials are $BaCO_3$ and $TiO_2$, which are mixed in suitable proportions and calcined, the resulting $BaTiO_3$ being pulverized to give a powder of $BaTiO_3$. Further starting materials $NiCO_3$, $Fe_2O_3$ and ZnO are mixed in suitable proportions, calcined, pulverized and granulated to give a calcined ferrite powder. Then the calcined ferrite powder is mixed with the $BaTiO_3$ powder in suitable proportions, and the mixture is moulded and sintered.

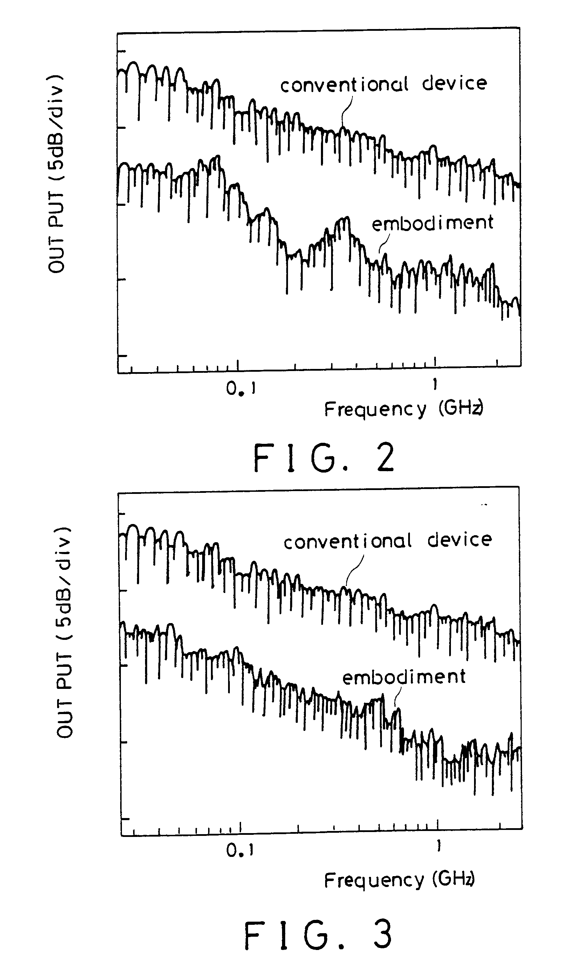

Fig. 2 shows the result of evaluation of leaked electromagnetic waves form an ordinary personal computer with and without the first form of electromagnetic wave suppressor member 3. The member was made of $(Ni_{0.3}Zn_{0.7})OFe_2O_3$ alone, and its volume was 1% of the internal volume of the computer. The graph shows that leakage of electromagnetic waves was reduced by c. 5 dB compared with conventional device except for those in certain frequency bands. In the particular frequency bands, as the electric field component is large, the level of reduction becomes smaller than in other frequency bands. The characteristics vary slightly depending on the location of the member because of the distribution of the electromagnetic field.

Fig. 3 shows the result of evaluating, by a method similar to that used for Fig. 2, leaked electromagnetic waves using a second form of suppressor member of a mixed material of $Ni_{0.3}Zn_{0.7})OFe_2O_3$ and $BaTiO_3$ which showed high values of both permittivity and permeability. It will be seen from this graph that the leakage of electromagnetic waves is reduced by 5 dB in all the frequency bands. When the position of the electromagnetic wave suppressor member was changed, similar results were obtained.

As to the volume ratio between the casing and the member, it is preferable to determine a suitable ratio depending on the loss factor of the material and the level to which the leaked electromagnetic waves are to be reduced.

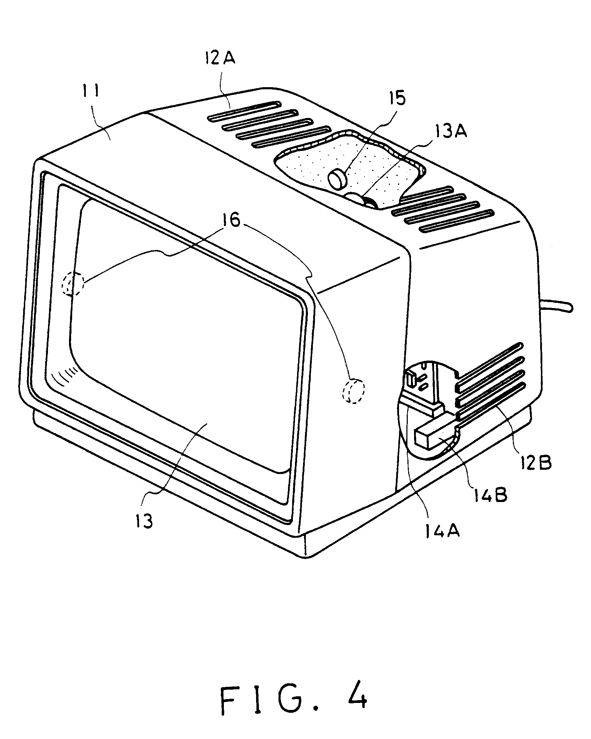

Fig. 4 shows the second embodiment of this invention wherein the electronic device is a display comprising a front casing 11 and a rear casing 12 made of mouldings of a plastics material, which mouldings serve to house a cathode-ray tube 13 and related parts 14A and 14B. The internal surfaces of the front and rear casings 11 and 12 are coated with an electroconductive paint and treated for electromagnetic shielding. The device has cooling vents 12A and 12B and an opening at the front. The major source of electromagnetic waves is the electron gun 13A of the cathode-ray tube 13.

Electromagnetic interference can be remarkably reduced by providing an electromagnetic wave suppressor member 15 having high permittivity close to the electron gun 13A and by providing electromagnetic wave suppressor members 16 having high permeability as shown with broken lines inside the front casing 11.

## Claims

1. An electrical device of which a casing is made mainly of electromagnetic wave shielding material and which is characterised in that an electromagnetic wave suppressor member mainly of a material having either high permeability and/or high permittivity at high frequencies and having electromagnetic loss is arranged inside the said casing.

2. An electrical device as claimed in claim 1, wherein at least one said electromagnetic wave suppressor member is positioned close to a portion of the casing where electromagnetic waves are less well shielded than at other portions of the casing.

3. An electrical device as claimed in claim 1 or claim 2, wherein at least one said electromagnetic wave suppressor member is positioned close to a circuit which is prone to the influence of electromagnetic waves or close to a circuit which is likely to generate electromagnetic waves which may interfere with other devices.

4. A method of reducing electromagnetic emissions from an electrical device, which comprises providing within a casing of the device an electromagnetic wave suppressor member mainly of a material having high permeability and/or high permittivity at high frequencies and having electromagnetic loss.

5. A method of protecting an electrical device against electromagnetic waves which comprises providing within a casing of the device an electromagnetic wave suppressor member mainly of a material having high permeability and/or high permittivity at high frequencies and having electromagnetic loss.

## Patentansprüche

1. Ein elektrisches Gerät, dessen Gehäuse hauptsächlich aus elektromagnetische Wellen abschirmendem Material hergestellt ist und das dadurch gekennzeichnet ist, daß innerhalb des Gehäuses ein Unterdrückerbauteil für elektromagnetische Wellen angeordnet ist, hauptsächlich aus einem Material bestehend mit entweder hoher Permeabilität und/oder hohem Dielektrizitätskoeffizienten bei hohen Frequenzen und mit elektromagnetischem Verlust.

2. Eine elektrisches Gerät nach Anspruch 1, bei dem mindestens ein solches Unterdrückerglied für elektromagnetische Wellen nahe einem Abschnitt des Gehäuses positioniert ist, wo elektromagnetische Wellen weniger gut abgeschirmt sind als an anderen Abschnitten des Gehäuses.

3. Ein elektrisches Gerät nach Anspruch 1 oder Anspruch 2, bei dem mindestens ein solches Unterdrückungsglied für elektromagnetische Wellen nahe einem Schaltkreis positioniert ist, der empfindlich gegenüber dem Einfluß elektromagnetischer Wellen ist oder nahe einem Schaltkreis, der wahrscheinlich elektromagnetische Wellen erzeugt, die mit anderen Bauteilen interferieren können.

4. Ein Verfahren zum Verringern der elektromagnetischen Emission von einem elektrischen Gerät, das vorsieht, innerhalb eines Gehäuses des Geräts ein Unterdrückerbauteil für elektromagnetische Wellen vorzusehen, welches hauptsächlich aus einem Material besteht mit hoher Permeabilität und/oder hohem Dielektrizitätskoeffizienten bei hohen Frequenzen und mit elektromagnetischem Verlust.

5. Ein Verfahren zum Schützen eines elektrischen Geräts gegen elektromagnetische Wellen, welches das Vorsehen, innerhalb eines Gehäuses des Geräts, eines Unterdrückergliedes für elektromagnetische Wellen umfaßt, das hauptsächlich aus einem Material mit hoher Permeabilität und/oder hohem Dielektrizitätskoeffizienten bei hohen Frequenzen und mit elektromagnetischem Verlust besteht.

## Revendications

1. Un dispositif électrique dont un boîtier est principalement constitué d'une matière de blindage contre les ondes électromagnétiques et qui est caractérisé en ce qu'il est agencé à l'intérieur dudit boitier un élément de suppression des ondes électromagnétiques, principalement en une matière, dont ou bien la perméabilité est élevée, et/ou la permissivité est élevée à des fréquences élevées, et dont la perte magnétique est élevée.

2. Un dispositif électrique selon la revendication 1, dans lequel au moins un dit élément de suppression d'ondes électromagnétiques est positionné près d'une partie du boitier où des ondes électromagnétiques sont moins bien blindées qu'à d'autres parties du boîtier.

3. Un dispositif électrique selon la revendication 1 ou la revendication 2, dans lequel au moins un dit élément de suppression d'ondes électromagnétiques est positionné près d'un circuit qui est sensible à l'influence d'ondes électromagnétiques ou près d'un circuit qui risque d'engendrer des ondes électromagnétiques qui peuvent interférer avec d'autres dispositifs.

4. Un procédé de réduction d'émissions électromagnétiques à partir d'un dispositif électrique qui comprend la mise en place, à l'intérieur d'un boîtier du dispositif, d'un élément de suppression des ondes électromagnétiques, principalement en une matière, dont ou bien la perméabilité est élevée, et/ou la permissivité est élevée à des fréquences élevées, et dont la perte magnétique est élevée.

5. Un procédé de protection d'un dispositif électrique contre les ondes électromagnétiques qui comprend la mise en place, à l'intérieur d'un boîtier du dispositif, d'un élément de suppression des ondes électromagnétiques, principalement en une matière, dont ou bien la perméabilité est élevée, et/ou la permissivité est élevée à des fréquences élevées, et dont la perte magnétique est élevée.

F I G . 1

F I G. 2

F I G. 3

FIG. 4